Europäisches Patentamt

(19) European Patent Office

Office européen des brevets

(11) Publication number : **0 440 268 B1**

(12) **EUROPEAN PATENT SPECIFICATION**

(45) Date of publication of patent specification :
17.08.94 Bulletin 94/33

(51) Int. Cl.⁵ : **G01B 11/30**, G01B 7/34,
G11B 11/08

(21) Application number : **91105521.8**

(22) Date of filing : **12.05.87**

(54) **Atomic force sensor head with interferometric measurement of the properties of a data store.**

(43) Date of publication of application :
07.08.91 Bulletin 91/32

(45) Publication of the grant of the patent :
17.08.94 Bulletin 94/33

(84) Designated Contracting States :
CH DE FR GB LI

(56) References cited :
US-A- 4 575 822
PHYSICA, vol. 24, 1958, pages 751-764, Amsterdam, NL; M.J. SPARNAAY:
"Measurements of attractive forces between flat plates"
NATURE, vol. 272, no. 5651, March 1978, pages 313-318, Basingstoke, GB; B.V. DERJAGUIN et al: "Direct measurement of molecular forces"

(60) Publication number of the earlier application in accordance with Art. 76 EPC : **0 290 648**

(73) Proprietor : **International Business Machines Corporation**
**Old Orchard Road**
**Armonk, N.Y. 10504 (US)**

(72) Inventor : **Pohl, Wolfgang Dieter, Dr.**
**Felsenhofstrasse 10**
**CH-8134 Adliswil (CH)**

(74) Representative : **Barth, Carl Otto et al**
**IBM Corporation**
**Zurich Intellectual Property Dept.**
**Säumerstrasse 4**
**CH-8803 Rüschlikon (CH)**

## Description

This invention relates generally to Atomic Force Microscopes (AFM) and more particularly to an atomic force sensor head for measuring the properties of a data store by interferometric means. A precondition for the applicability of the invention to data stores is that they show, at their surface, a variance in their molecular structure or arrangement of their molecules that depends on whether a data bit is stored or not stored. These data stores per se are not the subject of this invention.

The Atomic Force Microscope proposed by G. Binnig in EP-A-0 223 918 and described by G. Binnig, C.F. Quate and Ch. Gerber, Phys. Rev. Letters, Vol.56, No.9, March 1986, pp.930-933, employs a sharply pointed tip attached to a spring-like cantilever beam to scan the profile of a surface to be investigated. At the distances involved, minute forces occur between the atoms at the apex of the tip and those at the surface, resulting in a tiny deflection of the cantilever. In Binnig's proposal, this deflection is measured by means of a tunneling microscope, i.e., an electrically conductive tunnel tip is placed within tunnel distance from the back of the cantilever beam, and the variations of the tunneling current are used to determine the deflection. With known characteristics of the cantilever beam, the forces occurring between the AFM tip and the surface under investigation can be determined.

The forces occurring between a pointed tip and a surface are usually described as van-der-Waals, covalent, ionic, or repulsive core interaction forces. The energies involved in the atomic distance approach between single atoms respectively at the apex of the tip and on a surface are in the range of $E_0 = 0,01...10eV = 10^{-22}...10^{-18}$ Joule. The corresponding distances are in the subnanometer range of $x_0 = 10...1000$ pm $= 0,01...1$ nm. The respective forces (i.e. the first derivatives of the potential function, therefore, are in the range of $K_0 = 10$ pN ... 10 nN. The resulting atomic 'spring constants', i.e., the second derivatives of the potential function are in the range of $C_0 = 100...0,01$ N/m. These data can be deduced from surface studies and many other sources, such as the values of elastic constants.

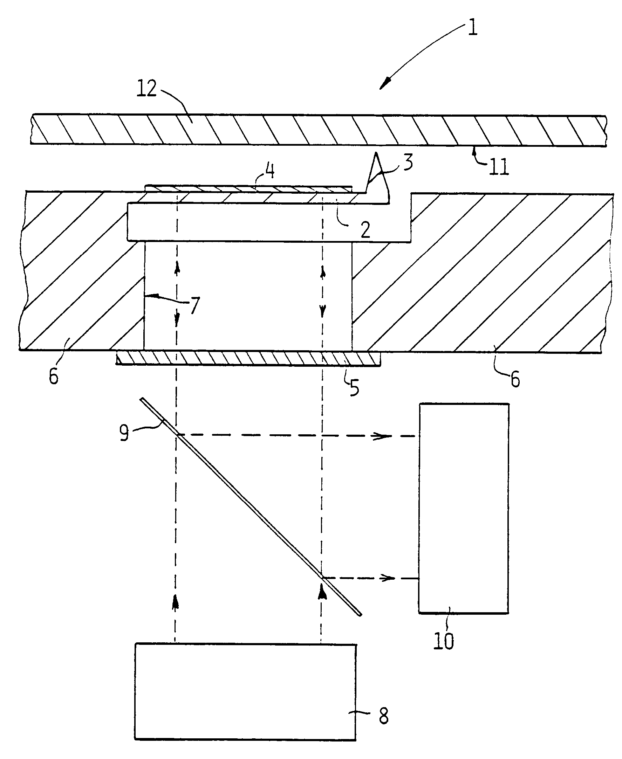

Experiments with van-der-Waals forces are reported in M.J. Sparnaay, "Measurements of Attractive Forces Between Flat Plates", Physica XXIV (1958) pp. 751-764. Fig. 2 of this reference shows a setup comprising a cantilever beam fixed at one end and bearing at half-length one plate of a pair of parallel plates, the other plate of which is mounted independent of the cantilever beam. The weight of the beam is balanced by a spring, and the deflection the beam undergoes upon interaction of the pair of plates is determined by the variation of a capacitor having one of its plates attached to the cantilever beam, while the other plate is fixed.

It is one object of the present invention to describe one embodiment of an atomic force measuring device which uses techniques alternative to tunneling, while keeping the cantilever as a force/deflection translator. The devices in accordance with the invention can be used as atomic force microscopes, but they may also find a wider field of application once available.

The present invention accordingly contemplates to teach an atomic force sensor head for measuring the properties of a data storage medium, comprising at least one cantilever beam fixed at one end and carrying an interaction member in a location distant from said fixed end for interaction with the surface of said storage medium to be investigated, and means for detecting the deflection of said cantilever beam as said interaction member interacts with the surface of said storage medium. Said detection means are designed to convert said deflection from the home position of said cantilever beam to a variation of an electrical value other than a tunneling current, from an initial level thereof. The sensor head of the invention is characterized in that said interaction member is designed as a pointed tip forming an integral part of said cantilever beam which in turn extends from a body across a via hole therein, that said cantilever beam carries a metal film, that said via hole on the side of said body opposite said said cantilever beam is closed with a half-transparent mirror, that a laser is aligned with the axis of said via hole, that a beam splitter is arranged at an angle in the path of the laser beam so as to deflect part of the light from said laser onto a photodetector, the arrangement forming a Fabry-Pérot interferometer with the value of the output signal from said photodetector being a measure for the deflection of said cantilever beam as its tip interacts with the surface of the storage medium.

Details of an embodiment of the invention will be described by way of example in the following description and with reference to the attached drawing which is a cross-section through a micromechanical sensor head arranged as a Fabry-Pérot interferometer.

It is known in the art that interferometric techniques permit the measurement of position changes down to less than 0,1 nm. The achievable sensitivity is comparable to capacitive and tunneling methods and sufficient for atomic force detection.

While optical methods generally have the disadvantage of requiring more complicated apparatus and alignment procedures than purely electronic methods, there are some important advantages over other methods:

1. The signal represents displacement averaged over a sizeable area of the cantilever beam, hence is not sensitive to singular atomic changes in the measurement zone.

2. The light beam exerts practically no forces on the cantilever beam.

3. The light beam allows for contact-free remote probing.

Referring to the single figure, there is shown an atomic force sensor head 1 which comprises a micromechanical cantilever beam 2 with a pointed tip 3. A metal film 4 coated on cantilever beam 2 forms a high-reflectivity mirror which is large in size as compared to the wavelength, for example $50 \times 300$ μm. A second, half-transparent mirror 5 is mounted on the rear side of the body 6 on which cantilever beam 2 is arranged. A via hole 7 between mirrors 4 and 5 permits the passage of light.

The two parallel mirrors 4 and 5 form a Fabry-Pérot interferometer. The spacing between them can be adjusted by electrostatic deflection of cantilever beam 2, using metal film 4 and body 6 as the electrodes. To this end, body 6 may consist of a doped semiconductor. Cantilever beam 2 can be lined up for maximum displacement sensitivity (which occurs at the slope of the Airy function describing the Fabry-Pérot reflection/transmission characteristics).

The interferometer is illuminated by a laser 8 from below body 6. A beam splitter 9 lets part of the light pass through via hole 7 onto the Fabry-Pérot interferometer 4/5. The light reflected from interferometer 4/5 gets deflected onto a photodetector 10. With the adjustment properly performed, any change in spacing between tip 3 and the surface 11 of the sample 12 under investigation, caused by forces acting on tip 2, will manifest itself as a variation of the reflected light intensity.

For best resolution, the atomic force sensor head embodiment just described should be operated under vacuum. Both, laser and photodetector may be placed inside the vacuum, and can be integrated into the micromechanical chip.

As the tip 3 is approached to the surface 11 of the sample 12, the nearmost atoms at tip and surface interact, developing a force between them which is determined by their interaction potential $U_{int}$, their distance r, and the spring constant C of cantilever beam 2. In equilibrium, i.e., when the atomic force $dU_{int}/dr$ balances the spring force C x, the deflection of cantilever beam 2 is given by:

$$U_{int} + \frac{1}{2} C x^2 = Min.$$

The embodiment shown may be adjusted to yield a static deflection $x \simeq 10 \ldots 100$ pm which can be detected statically. Cantilever beam 2 also is a harmonic oscillator with an eigenfrequency $\omega_0$. In the presence of the said atomic interaction, the resonance frequency of cantilever beam 2 is shifted in accordance with

$$\omega^2 = \omega_0^2 \left( 1 + \frac{1}{C} \frac{d^2 U_{int}}{dr^2} \right).$$

This term assumes that higher-order terms of the interaction potential do not contribute to the equation of motion. The measurement of the frequency shift has the great advantage of eliminating the length measurement, resulting in simplified calibration of the sensor head.

The design of this sensor head has to be optimized with regard to opposing requirements: For the sake of high sensitivity, a weak spring constant C is desirable. However, the maximum tolerable amplitude of the thermal vibrations of the arrangement poses a lower limit. Furthermore, C should be larger than the maximum of $d^2U_{int}/dr^2$, lest metastable equilibrium positions should exist, rendering reliable operation of the sensor head impossible. This might become a severe problem in the case of the short-range covalent binding interaction where second derivatives of the potential of the order of 10...100 N/m are to be expected. Accordingly, a rather stiff cantilever beam is desirable.

To permit detailed investigation of the weak attractive forces between two atoms, i.e., the second derivative of the interaction potential $C_{int} = d^2U_{int}/dr^2$, the embodiment shown should be dimensioned in accordance with the following considerations:

The second derivative $C_{int}$ of the interaction potential $U_{int}$ and the measured frequency shift $\Delta\omega$ are related as follows:

$$C_{int} = 2 C_{eff} \frac{\Delta\omega}{\omega_0},$$

where $C_{eff}$ is approximately equal to the static spring constant of cantilever beam 2. The detection threshold $C_{min}$ can be expressed in terms of the eigenfrequency $(\omega)_0$, the Q factor of the resonator, and the integration time $\tau$ of the frequency measurement:

$$C_{min} = 2 \frac{C_{eff}}{\sqrt{Q\omega_0\tau}}.$$

$C_{min}$ is chosen at 0.01 N/m; a Q factor of 1000 for a micromechanical cantilever beam has recently been established; the integration time $\tau$ must not exceed 10 ms in order to allow for constant force scanning microscopy in addition to the measurement of the interaction potential $U_{int}$; and the eigenfrequency $\omega_0$ should be about $2\pi \times 10$kHz in order to allow for adequate isolation from ambient vibrations. With these parameters, one obtains $C_{eff} = 4$ N/m and a detector sensitivity of 1,25 kHz/(N/m). In other words, a $C_{min}$ of 0,01 N/m gives rise to a frequency shift of 12,5 Hz. The rms amplitude of the thermal vibrations is 0,016 nm at liquid nitrogen temperature and 0,03 nm at room temperature.

Terms of the interaction potential $U_{int}$ of an order greater than 3 give rise to an additional frequency shift proportional to the square of the vibration amplitude. This frequency shift causes an ambiguity $C_{ah}$ of the measured $C_{int}$ of the order of

$$C_{ah} < \frac{1}{8} \left| \frac{d^4 U_{int}}{dr^4} \right| x_{th}^2.$$

Considering the fact that $C_{eff} = K \cdot f_R$, with K being a constant close to unity, the dimensions for cantilever 2 can be calculated from the following equations for the force constant $f_R$ and for the resonant frequency $\omega_0$:

$$f_R = \frac{1}{4} E \frac{w t^3}{l^3}$$
$$\omega_0 = 1{,}02 \left(\frac{E}{\rho}\right)^{\frac{1}{2}} \frac{t}{l^2},$$

wherein $E = 7{,}2 \times 10^{10}$ N/m$^2$ is Young's modulus of elasticity for SiO$_2$, w, t and l are respectively width, thickness and length of cantilever 2, and $\rho$ 2,2 × 10$^3$ kg/m$^3$ is the specific density of the cantilever material. With the parameters indicated above and with the realistic assumption that w = 8t, the dimensions of the cantilever beam result as w = 115 μm, t = 14 μm, and l = 1150 μm.

## Claims

1. Atomic force sensor head (1) for measuring the properties of a data storage medium (12), comprising at least one cantilever beam (2) fixed at one end and carrying an interaction member (3) in a location distant from said fixed end for interaction with the surface (11) of said storage medium (12) to be investigated, and means (4...10) for detecting the deflection of said cantilever beam (2) as said interaction member (3) interacts with the surface (11) of said storage medium (12), wherein said detection means (4...10) are designed to convert the deflection of said cantilever beam (2) into a variation of an electrical value, other than a tunneling current, from an initial level thereof, *characterized* in that said interaction member is designed as a pointed tip (3) forming an integral part of said cantilever beam (2) which in turn extends from a body (6) across a via hole (7) therein, that said cantilever beam (2) carries a metal film (4), that said via hole (7) on the side of said body (6) opposite said said cantilever beam (2) is closed with a half-transparent mirror (5), that a laser (8) is aligned with the axis of said via hole (7), that a beam splitter (9) is arranged at an angle in the path of the laser beam so as to deflect part of the light from said laser (8) onto a photodetector (10), the arrangement forming a Fabry-Pérot interferometer with the value of the output signal from said photodetector (10) being a measure for the deflection of said cantilever beam (2) as its tip (3) interacts with the surface (11) of the storage medium (12).

2. Atomic force sensor head in accordance with claim 1, *characterized* in that said cantilever beam (2) is designed so that its force constant $f_R$ and its resonant frequency $\omega_0$ respectively obey the following equations:

$$f_R = \frac{1}{4} E \frac{w t^3}{l^3}$$
$$\omega_0 = 1{,}02 \left(\frac{E}{\rho}\right)^{\frac{1}{2}} \frac{t}{l^2},$$

wherein E is Young's modulus of elasticity; w, t and l are respectively width, thickness and length of the cantilever (2), and $\rho$ is the specific density of the cantilever material.

## Patentansprüche

1. Atomarer Kräftesensorkopf (1) zum Messen der Eigenschaften eines Datenspeichermediums (12), mindestens einen Freiträger (2) umfassend, der an einem Ende befestigt ist, und der ein Interaktionselement (3) trägt, in einem Abstand von dem genannten festen Ende, zur Interaktion mit der Oberfläche (11) des genannten zu prüfenden Speichermediums (12), und Mittel (4...10) zum Erfassen der Auslenkung des genannten Freiträgers (2), wenn das genannte Interaktionselement (3) mit der Oberfläche (11) des genannten Speichermediums (12) in Wechselwirkung tritt, wobei die genannten Erfassungsmittel (4...10) so gestaltet sind, daß sie die Auslenkung des genannten Freiträgers (2), ausgehend von einem Ausgangswert dieses Werts, in eine Veränderung eines elektrischen Werts, der kein Tunnelstrom ist, umwandeln, dadurch gekennzeichnet, daß das genannte Interaktionselement als eine feine Spitze (3) ausgestaltet ist, die einen integrierten Bestandteil des genannten Freiträgers (2) bildet, der seinerseits von einem Körper (6) aus über ein darin angeordnetes Durchkontaktloch (7) verläuft, daß der genannte Freiträger (2) einen Metallfilm (4) trägt, daß das genannte Durchkontaktloch (7) auf der Seite des genannten Körpers (6) gegenüber dem genannten Freiträger (2) mit einem halbtransparenten Spiegel (5) verschlossen ist, daß ein Laser (8) mit der Achse des genannten Durchkontaktlochs (7) ausgerichtet ist, daß ein Strahlenteiler (9) in einem bestimmten Winkel in dem Pfad des Laserstrahls angeordnet ist, so daß ein Teil des Lichts von dem genannten Laser (8) auf einen Fotodetektor (10) abgelenkt wird, wobei die Anordnung einen Fabry-Pérot-Interferometer bildet, und der Wert des Ausgangssignals von dem genannten Fotodetektor (10) ein Maß für die Auslenkung des genannten Freiträgers (2) ist, wenn seine Spitze (3) in Wechselwirkung mit der Oberfläche (11) des Speichermediums (12) tritt.

**2.** Atomarer Kräftesensorkopf nach Anspruch 1, dadurch gekennzeichnet, daß der genannte Freiträger (2) so konstruiert ist, daß seine Kraftkonstante $f_R$ beziehungsweise seine Resonanzfrequenz $\omega_0$ den folgenden Gleichungen gehorchen:

$$f_R = \frac{1}{4} E \frac{w\, t^3}{l^3}$$

$$\omega_0 = 1{,}02 \left(\frac{E}{\rho}\right)^{\frac{1}{2}} \frac{t}{l^2},$$

hierbei ist E das Elastizitätsmodul nach Young; w, t und 1 sind Breite, Dicke beziehungsweise Länge des Freiträgers (2) und $p$ ist die spezifische Dichte des Freiträgermaterials.

## Revendications

**1.** Tête de détection de forces atomiques (1) pour mesurer les propriétés d'un support d'informations (12), comprenant au moins un porte-à-faux (2) fixe en l'une de ses extrémités et portant un élément d'interaction (3) situé à une certaine distance de ladite extrémité fixe pour interagir avec la surface (11) du dit support d'informations (12) à inspecter, et des dispositifs (4...10) pour détecter la déflexion du dit porte-à-faux (2) lorsque ledit élément d'interaction (3) interagit avec la surface (11) du dit support d'informations (12), dans laquelle les dits dispositifs détecteurs (4...10) sont conçus pour convertir la déflexion du dit porte-à-faux (2) en une variation d'une valeur électrique, autre qu'un courant par effet de tunnel, à partir d'un niveau initial de celle ci, *caractérisée en ce que* ledit élément d'interaction est conçu sous la forme d'une pointe effilée (3) formant partie intégrante du dit porte-à-faux (2), ce dernier traversant, à partir d'un corps principal (6), un trou traversant (7) percé dans celui-ci; ledit porte-à-faux (2) porte une mince couche métallique (4); ledit trou traversant (7), sur le côté du dit corps principal (6) opposé au dit porte-à-faux (2), est clos à l'aide d'un miroir semi-transparent (5); un laser (8) est aligné avec l'axe du dit trou traversant (7); un dispositif de décomposition de faisceau (9) est disposé selon un certain angle sur le trajet du faisceau pour défléchir une partie de la lumière du dit laser (8) sur un photodétecteur (10), cette disposition formant un interféromètre où la valeur du signal de sortie du dit photodétecteur (10) est une mesure de la déflexion du dit porte-à-faux (2) lorsque sa pointe (3) interagit avec la surface (11) du dit support d'informations (12).

**2.** Tête de détection de forces atomiques selon la revendication 1, *caractérisée en ce que* ledit porte-à-faux (2) est conçu en sorte que sa constante de force $f_R$ et sa fréquence de résonance $\omega_0$

obéissent respectivement aux équations suivantes:

$$f_R = \frac{1}{4} E \frac{w\, t^3}{l^3}$$

$$\omega_0 = 1{,}02 \left(\frac{E}{\rho}\right)^{\frac{1}{2}} \frac{t}{l^2}$$

où E est le module d'élasticité de Young; w, t et 1 sont, respectivement, la largeur, l'épaisseur et la longueur du porte-à-faux (2); et $\rho$ est la densité spécifique du matériau du porte-à-faux.